# EUROPEAN PATENT APPLICATION

(11) **EP 4 583 649 A1**
(43) Date of publication of application: **09.07.2025**
(21) Application number: 23948670.7
(22) Date of filing: 07.11.2023
(51) Int. Cl.: H05K 7/20, H05K 1/02, H05K 1/18

(54) **HEAT DISSIPATION APPARATUS, HEAT DISSIPATION SYSTEM, AND HEAT DISSIPATION DEVICE FOR OPTICAL MODULE**

(71) Applicant: Ruijie Networks Co., Ltd., Fuzhou, Fujian 350002 (CN)
(72) Inventor: LIANG, Zhaokuan, Fuzhou, Fujian 350002 (CN)
(74) Representative: Mathys & Squire
(86) International application number: PCT/CN2023/130314
(87) International publication number: WO 2025/097320

(57) **Abstract**

This application relates to the field of heat dissipation technologies, and in particular, to a heat dissipation apparatus, a heat dissipation system, and a heat dissipation device for an optical module. The heat dissipation apparatus includes a housing, at least one dividing assembly, at least one first heat dissipation structure, and at least one first heat transfer structure. The housing includes a receiving cavity. The at least one dividing assembly is located in the receiving cavity, and the at least one dividing assembly is configured to divide the receiving cavity into a first sub receiving cavity and at least one second sub receiving cavity. One side that is of the first heat dissipation structure and that faces toward a bottom plate of the housing is located in the second sub receiving cavity. One end of the first heat transfer structure is connected to the first heat dissipation structure, and another end of the first heat transfer structure is configured to be connected to a heat exchange apparatus through the housing. The heat dissipation apparatus provided in this application can ensure that heat generated by the plug-in terminal inserted in and connected to the second sub receiving cavity can be dissipated in time.

## Description

### TECHNICAL FIELD

This application relates to the field of heat dissipation technologies, and in particular, to a heat dissipation apparatus, a heat dissipation system, and a heat dissipation device for an optical module.

### BACKGROUND

In a conventional technology, for heat dissipation of an optical module, two plug-in terminals of the optical module need to be inserted into a heat dissipation cage for heat dissipation. However, in this disposition, a plug-in terminal located below may generate a lot of heat.

### SUMMARY

This application provides a heat dissipation apparatus, a heat dissipation system, and a heat dissipation device for an optical module, where heat in a first heat dissipation structure of the heat dissipation apparatus can be conducted through a first heat transfer structure, thereby improving a heat dissipation capability of the first heat dissipation structure, and further ensuring that heat generated by a plug-in terminal inserted in and connected to a second sub receiving cavity can be dissipated in time.

To achieve the foregoing objective, according to a first aspect, this application provides a heat dissipation apparatus, including a housing, at least one dividing assembly, at least one first heat dissipation structure, and at least one first heat transfer structure, where the housing includes a bottom plate, a top plate, and a side plate, the side plate is configured to connect the top plate to the bottom plate, a receiving cavity with an opening at one end is formed by an enclosure of the top plate, the bottom plate, and the side plate, the at least one dividing assembly is located in the receiving cavity, and the at least one dividing assembly is configured to divide the receiving cavity into a first sub receiving cavity and at least one second sub receiving cavity; one side of the first heat dissipation structure and facing toward the bottom plate is located in the second sub receiving cavity; and one end of the first heat transfer structure is connected to the first heat dissipation structure, and another end of the first heat transfer structure is configured to be connected to a heat exchange apparatus.

In this embodiment, the dividing assembly divides the receiving cavity of the housing into one first sub receiving cavity and at least one second sub receiving cavity, and a second heat dissipation structure dissipates heat for a plug-in terminal inserted in and connected to the first sub receiving cavity. Heat absorbed by the first heat dissipation structure can be transferred to the heat exchange apparatus through the first heat transfer structure, so that the heat absorbed by the first heat dissipation structure can be rapidly dissipated. This increases a heat dissipation speed of the plug-in terminal inserted in and connected to the second sub receiving cavity, prevents an excessively high temperature of the plug-in terminal inserted in and connected to the second sub receiving cavity, and prolongs a service life of an optical module.

In an embodiment, the other end of the first heat transfer structure is connected to the heat exchange apparatus through the side plate.

In an embodiment, the first heat transfer structure includes a first heat pipe, the first heat pipe is in a flat shape, one end of the first heat pipe is connected to the first heat dissipation structure, and another end of the first heat pipe is configured to be connected to the heat exchange apparatus. In an embodiment, the other end of the first heat pipe is configured to be connected to the heat exchange apparatus through the side plate.

In an embodiment, the first heat transfer structure includes a heat transfer baseplate and a first heat pipe, the first heat pipe is in a flat shape, the heat transfer baseplate is connected to the first heat dissipation structure, one end of the first heat pipe is fixedly connected to the heat transfer baseplate, and the other end of the first heat pipe is configured to be connected to the heat exchange apparatus.

In an embodiment, the first heat pipe includes a first pipe body and a second pipe body that communicate with each other, the first pipe body is disposed in parallel with the heat transfer baseplate, the first pipe body is fixedly connected to the heat transfer baseplate, the second pipe body is disposed at an angle with the first pipe body, and the second pipe body is configured to be connected to the heat exchange apparatus.

In an embodiment, the first heat pipe includes a first pipe body, a flexible connection pipe body, and a second pipe body, the flexible connection pipe body is configured to communicate between the first pipe body and the second pipe body, the first pipe body is configured to fixedly be connected to the heat transfer baseplate, and the second pipe body is configured to be connected to the heat exchange apparatus.

In an embodiment, each dividing assembly is configured to mount one first heat dissipation structure.

In an embodiment, the heat dissipation apparatus includes a second heat dissipation structure, and the second heat dissipation structure is connected to one side that is of the top plate and that faces away from the bottom plate.

In an embodiment, the heat dissipation apparatus includes a second heat transfer structure, and the second heat transfer structure is connected to a second heat dissipation structure.

In an embodiment, the second heat transfer structure includes a second heat pipe, one end of the second heat pipe is connected to the second heat dissipation structure, and another end of the second heat pipe is configured to be connected to the heat exchange apparatus.

In an embodiment, the second heat pipe is in a flat shape.

In an embodiment, the first heat transfer structure includes a first liquid inlet pipe and a first liquid outlet pipe, one end of the first liquid inlet pipe communicates with the first heat dissipation structure through the side plate, another end of the first liquid inlet pipe is configured to communicate with the heat exchange apparatus, one end of the first liquid outlet pipe communicates with the first heat dissipation structure through the housing, and another end of the first liquid outlet pipe is configured to communicate with the heat exchange apparatus; and the second heat transfer structure includes a second liquid inlet pipe and a second liquid outlet pipe, one end of the second liquid inlet pipe communicates with the second heat dissipation structure, another end of the second liquid inlet pipe is configured to communicate with the heat exchange apparatus, one end of the second liquid outlet pipe communicates with the second heat dissipation structure, and another end of the second liquid inlet pipe communicates with the first heat dissipation structure.

In an embodiment, the first heat transfer structure includes a first liquid inlet pipe and a first liquid outlet pipe, and the second heat transfer structure includes a second liquid inlet pipe and a second liquid outlet pipe; and
one end of the second liquid inlet pipe communicates with the second heat dissipation structure, another end of the second liquid inlet pipe is configured to communicate with the heat exchange apparatus, one end of the second liquid outlet pipe communicates with the second heat dissipation structure, another end of the second liquid outlet pipe communicates with one end of the first liquid inlet pipe, another end of the first liquid inlet pipe communicates with the first heat dissipation structure, one end of the first liquid outlet pipe communicates with the first heat dissipation structure through the housing, and another end of the first liquid outlet pipe is configured to communicate with the heat exchange apparatus.

In an embodiment, the first heat transfer structure includes a first liquid inlet pipe and a first liquid outlet pipe, and the second heat transfer structure includes a second liquid inlet pipe and a second liquid outlet pipe; one end of the first liquid inlet pipe communicates with the first heat dissipation structure through the side plate, another end of the first liquid inlet pipe communicates with the second heat dissipation structure, one end of the first liquid outlet pipe communicates with the first heat dissipation structure through the housing, and another end of the first liquid outlet pipe communicates with the second heat dissipation structure; and one end of the second liquid inlet pipe communicates with the second heat dissipation structure, another end of the second liquid inlet pipe is configured to communicate with the heat exchange apparatus, one end of the second liquid outlet pipe communicates with the second heat dissipation structure, and another end of the second liquid outlet pipe communicates with the heat exchange apparatus.

In an embodiment, there are a plurality of housings, and the second heat dissipation structure is fixedly connected to top plates included in the plurality of housings.

In an embodiment, the second heat dissipation structure is capable of moving close to or away from the bottom plate relative to the top plate; and the first heat dissipation structure is capable of moving close to or away from the bottom plate relative to the dividing assembly.

According to a second aspect, this application further provides a heat dissipation system. The heat dissipation system includes a heat exchange apparatus and heat dissipation apparatuses, where the plurality of heat dissipation apparatuses are sequentially disposed at intervals, and a first heat transfer structure and a second heat transfer structure included in each heat dissipation apparatus are both connected to the heat exchange apparatus. In the heat dissipation system provided in this application, when a plug-in terminal of an optical module is inserted in and connected to each heat dissipation apparatus, because a second heat dissipation structure and a first heat dissipation structure in each heat dissipation apparatus are both capable of moving, it can be ensured that the heat dissipation system is applicable to optical modules with plug-in terminals in different sizes, and further, applicability of the heat dissipation system can be improved.

According to a third aspect, this application further provides a heat dissipation device for an optical module. The heat dissipation device includes the foregoing heat dissipation apparatus and at least one optical module, where the optical module includes a body and plug-in terminals connected to the body, and the plug-in terminals are inserted in and connected to a first sub receiving cavity and a second sub receiving cavity included in the heat dissipation apparatus. In this manner, heat generated by the plug-in terminal of the optical module can be quickly dissipated, and a service life of the optical module is prolonged.

### BRIEF DESCRIPTION OF DRAWINGS

FIG. 1 is a heat dissipation apparatus according to an embodiment of this application.
FIG. 2 is an exploded view of FIG. 1.
FIG. 3 is another exploded view of FIG. 1.
FIG. 4 is a schematic structural diagram of a dividing assembly in a heat dissipation apparatus according to an embodiment of this application.
FIG. 5 is another schematic structural diagram of a dividing assembly in a heat dissipation apparatus according to an embodiment of this application.
FIG. 6 is a partial schematic structural diagram of a housing in a heat dissipation apparatus according to an embodiment of this application.
FIG. 7 is a schematic structural diagram of a first heat dissipation structure in a heat dissipation apparatus according to an embodiment of this application.
FIG. 8 is a schematic structural diagram of a connection between a first heat dissipation structure and a first heat transfer structure in a heat dissipation apparatus according to an embodiment of this application.
FIG. 9 is another schematic structural diagram of a connection between a first heat dissipation structure and a first heat transfer structure in a heat dissipation apparatus according to an embodiment of this application.
FIG. 10 is another schematic structural diagram of a connection between a first heat dissipation structure and a first heat transfer structure in a heat dissipation apparatus according to an embodiment of this application.
FIG. 11a is a schematic structural diagram of a first heat pipe according to an embodiment of this application.
FIG. 11b is another schematic structural diagram of a first heat pipe according to an embodiment of this application.
FIG. 12 is another schematic structural diagram of a heat dissipation apparatus according to an embodiment of this application.
FIG. 13 is another schematic structural diagram of a heat dissipation apparatus according to an embodiment of this application.
FIG. 14 is another schematic structural diagram of a heat dissipation apparatus according to an embodiment of this application.
FIG. 15 is another schematic structural diagram of a heat dissipation apparatus according to an embodiment of this application.

### Reference numerals:

10. housing;
11. bottom plate;
12. top plate;
13. side plate;
   130. first side plate;
   131. second side plate;
14. first sub receiving cavity;
15. second sub receiving cavity;
20. second heat dissipation structure;
21. second heat dissipation main plate;
22. second heat dissipation fin group;
30. dividing assembly;
31. dividing plate;
   310. first opening;
   311. first elastic part;
   312. first plate body;
   313. second plate body;
   314. third plate body;
32. dividing side plate;
   320. connecting plate;
   321. bearing plate;
   322. limiting opening;
40. first heat dissipation structure;
41. first heat dissipation main plate;
42. contact plate;
43. first heat dissipation fin group;
44. liquid cooling radiator;
50. first elastic clamping part;
60. second elastic clamping part;
70. first heat transfer structure;
71. heat transfer baseplate;
72. first heat pipe;
   720. first pipe body;
   721. second pipe body;
   722. flexible connection pipe body;
73. first liquid inlet pipe;
74. first liquid outlet pipe;
80. second heat transfer structure;
81. second heat pipe;
82. second liquid inlet pipe;
83. second liquid outlet pipe;
90. fastening assembly.

### DESCRIPTION OF EMBODIMENTS

To make the objectives, technical solutions, and advantages of this application clearer, the following further describes this application in detail with reference to the accompanying drawings.

In a conventional technology, for heat dissipation of an optical module, two plug-in terminals of the optical module need to be inserted into a heat dissipation cage for heat dissipation. In this disposition, a plug-in terminal located below may generate a lot of heat. However, the heat dissipation cage cannot dissipate the heat generated by the plug-in terminal located below. This may further cause a temperature of the plug-in terminal to be excessively high, and affect performance and a service life of the optical module.

Therefore, a novel heat dissipation apparatus is urgently needed to resolve the foregoing technical problem.

Terms used in the following embodiments are merely intended to describe specific embodiments, but are not intended to limit this application. As used in the specification of this application and the appended claims, singular expression forms "one", "a/an", "the", "the foregoing", and "this" are intended to also include expression forms such as "one or more", unless explicitly specified in the context to the contrary.

Reference to "an embodiment" or "some embodiments" or the like described in this specification means that one or more embodiments of this application include a specific feature, structure, or characteristic described with reference to the embodiment. Therefore, expressions such as "in an embodiment", "in some embodiments", "in some other embodiments", and "in some different embodiments" that appear at different places in this specification do not necessarily indicate reference to a same embodiment, but mean "one or more but not all embodiments", unless otherwise specially emphasized. The terms "comprise", "include", and "have", and variants thereof all mean "including but not limited to", unless otherwise specially emphasized.

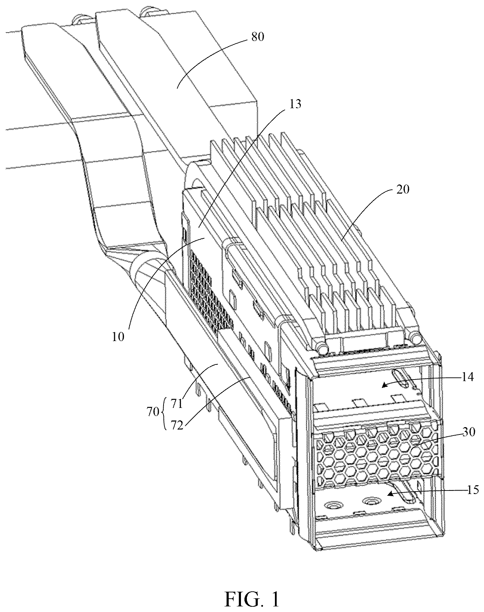

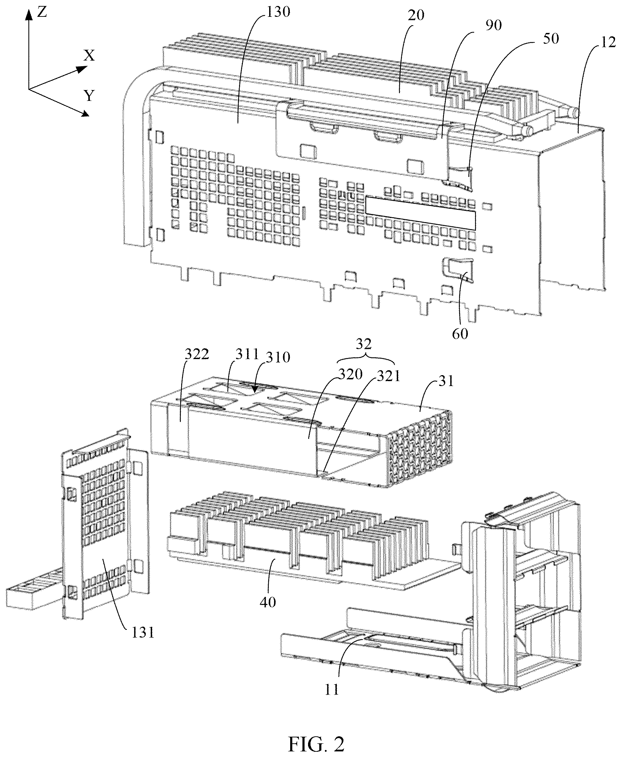

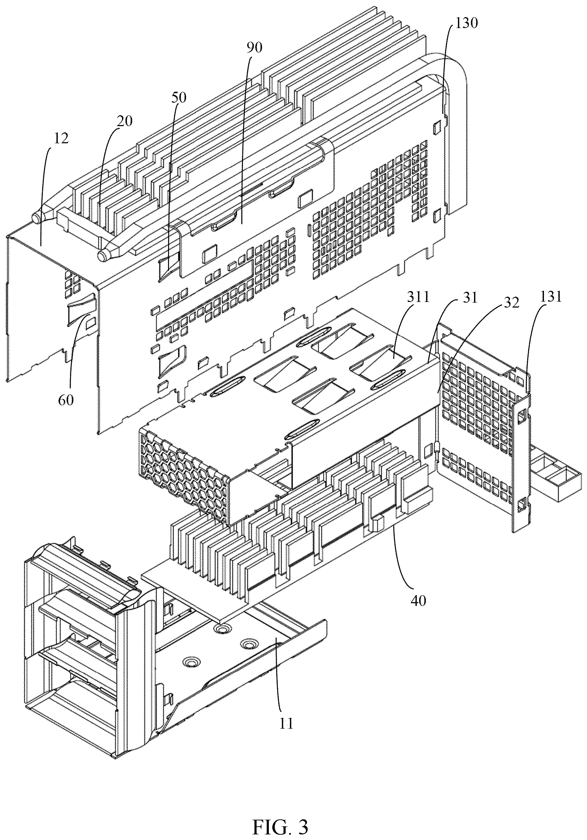

FIG. 1 is a heat dissipation apparatus according to an embodiment of this application. FIG. 2 and FIG. 3 are exploded views of FIG. 1. With reference to FIG. 1 to FIG. 3, the heat dissipation apparatus includes a housing 10, at least one dividing assembly 30, at least one first heat dissipation structure 40, and at least one first heat transfer structure 70. In an embodiment, the dividing assembly 30 is disposed in a one-to-one correspondence with the first heat transfer structure 70, and the first heat transfer structure 70 is disposed in a one-to-one correspondence with the first heat dissipation structure 40. The housing 10 includes a top plate 12, a bottom plate 11, and a side plate 13. The side plate 13 connects the top plate 12 to the bottom plate 11, and a receiving cavity with an opening at one end is formed by an enclosure of the side plate 13, the top plate 12, and the bottom plate 11. The top plate 12 and the bottom plate 11 may be in a shape of a rectangle, a circle, or a polygon. Generally, the top plate 12 and the bottom plate 11 are both rectangular for ease of arrangement. The side plate 13 may include two first side plates 130 and one second side plate 131, the two first side plates 130 are disposed at an interval along a first direction X, and the second side plate 131 connects the two first side plates 130. Specifically, the second side plate 131 may be connected to the first side plates 130 by clamping, to facilitate assembly of the housing 10.

With continued reference to FIG. 1 to FIG. 3, the at least one dividing assembly 30 is located in the receiving cavity, the at least one dividing assembly 30 may be connected to the two first side plates 130, and the at least one dividing assembly 30 divides the receiving cavity into a first sub receiving cavity 14 and at least one second sub receiving cavity 15. One side of the first heat dissipation structure 40 and facing toward the bottom plate 11 is located in the second sub receiving cavity 15. In this embodiment, the first sub receiving cavity 14 and the second sub receiving cavity 15 are configured to be inserted into and connected to plug-in terminals of an optical module, and the plug-in terminal located in the second sub receiving cavity 15 exchanges heat with the first heat dissipation structure 40 to implement heat dissipation of the optical module. Heat absorbed by the first heat dissipation structure 40 can be continuously transferred to a heat exchange apparatus through the first heat transfer structure 70. Therefore, it is ensured that the first heat dissipation structure 40 is at a relatively low temperature, thereby improving a heat dissipation capability of the first heat dissipation structure 40, and further ensuring that heat generated by the plug-in terminal inserted into and connected to the second sub receiving cavity 15 can be dissipated in time.

The heat exchange apparatus may be a cold plate or a liquid cooling structure.

In an embodiment, the heat dissipation apparatus may include one, two, or three dividing assemblies 30. When a quantity of the dividing assembly 30 is one, the dividing assembly 30 is between the bottom plate 11 and the top plate 12, and the dividing assembly 30 divides the receiving cavity into one first sub receiving cavity 14 and one second sub receiving cavity 15. When a quantity of the dividing assemblies 30 is two, the two dividing assemblies 30 are disposed at an interval between the top plate 12 and the bottom plate 11, and the two dividing assemblies 30 divide the receiving cavity into one first sub receiving cavity 14 and two second sub receiving cavities 15. When a quantity of the dividing assemblies 30 is three, the three dividing assemblies 30 are disposed at intervals between the top plate 12 and the bottom plate 11, and the three dividing assemblies 30 divide the receiving cavity into one first sub receiving cavity 14 and three second sub receiving cavities 15.

With continued reference to FIG. 1 to FIG. 3, in some embodiments, the heat dissipation apparatus includes a second heat dissipation structure 20. The second heat dissipation structure 20 is located at one side that is of the top plate 12 and that faces away from the bottom plate 11. The top plate 12 is connected to the second heat dissipation structure 20. A plug-in terminal located in the first sub receiving cavity 14 exchanges heat with the second heat dissipation structure 20, to ensure that heat generated by the plug-in terminal inserted in and connected to the first sub receiving cavity 14 can be dissipated in time.

To facilitate understanding, in this application, the first direction X is a direction in which the two first side plates 130 are arranged, a second direction Y is an extension direction of open ends of the first sub receiving cavity 14 and the second sub receiving cavity 15 to the bottom, and a third direction Z is a direction in which the bottom plate 11 and the top plate 12 are arranged. The first direction X, the second direction Y, and the third direction Z are perpendicular to each other. It should be noted that "perpendicular" defined in this embodiment of this application is not limited to a relationship of an absolute intersection angle of 90 degrees, but allows a non-absolutely perpendicular relationship caused by factors such as impact of an assembly tolerance, a design tolerance, and structural flatness, and allows an error within a small angle range. For example, 80 degrees to 100 degrees may be understood as a perpendicular relationship within an assembly error range.

In the following description, one dividing assembly disposed in the housing included in the heat dissipation apparatus is described as an example.

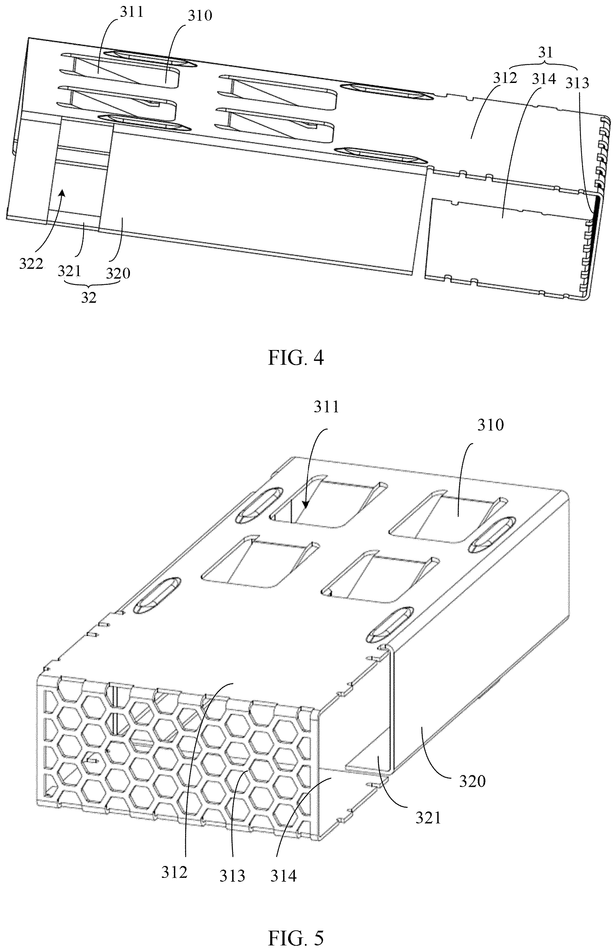

FIG. 4 is a schematic structural diagram of a dividing assembly in a heat dissipation apparatus according to an embodiment of this application. FIG. 5 is another schematic structural diagram of a dividing assembly in a heat dissipation apparatus according to an embodiment of this application. With reference to FIG. 3 to FIG. 5, each dividing assembly 30 is configured to mount one first heat dissipation structure 40. The dividing assembly 30 includes a dividing plate 31 and two dividing side plates 32. The two dividing side plates 32 are disposed opposite to each other along the first direction X. The two dividing side plates 32 are connected to one side that is of the dividing plate 31 and that faces toward the bottom plate 11. The dividing side plate 32 includes a connecting plate 320 and a bearing plate 321 connected to the connecting plate 320. The bearing plates 321 are located between two connecting plates 320. Two bearing plates 321 are disposed at an interval along the first direction X. The first heat dissipation structure 40 is arranged in and passes through the dividing assembly 30 through a space between the two connecting plates 320 in the first direction X. The two bearing plates 321 are configured to bear the first heat dissipation structure 40. When the first heat dissipation structure 40 is disposed in the dividing assembly 30 through the dividing side plates 32, a part of the first heat dissipation structure 40 can access the second sub receiving cavity 15 through a space between the two bearing plates 321, to ensure that when the plug-in terminal of the optical module is inserted in and connected to the second sub receiving cavity 15, the plug-in terminal of the optical module can be in contact with the first heat dissipation structure 40.

In an embodiment, the dividing plate 31 includes at least one first opening 310, the first opening 310 is configured to dispose a first elastic part 311, and the first elastic part 311 extends to the bearing plate 321. When the first heat dissipation structure 40 is disposed in the dividing assembly 30, the first elastic part 311 can abut against the first heat dissipation structure, so that the first heat dissipation structure 40 can move along the third direction Z. Therefore, the second sub receiving cavity 15 can receive plug-in terminals in different sizes. In this case, it may be understood that the first heat dissipation structure 40 is disposed in the dividing assembly, and the first heat dissipation structure 40 can move close to or away from the bottom plate relative to the dividing assembly. In some embodiments, the dividing plate 31 includes one first opening 310, and one first elastic part 311 is disposed in the first opening 310, or a plurality of first elastic parts 311 are disposed in the first opening 310. In some embodiments, the dividing plate 31 includes a plurality of first openings 310, one first elastic part 311 is disposed in each first opening 310, and the plurality of first openings 310 are disposed in array in the dividing plate 31.

In some embodiments, the dividing plate 31 includes a first plate body 312, a second plate body 313, and a third plate body 314 that are sequentially connected to one another, and the first opening 310 and the first elastic part 311 are both disposed in the first plate body 312. The first plate body 312 may be disposed in parallel with the third plate body 314. The connecting plate 320 is located between the second plate body 313 and the second side plate. A length of the connecting plate 320 is less than a length of the dividing plate 31 along the second direction Y, which may be understood that the length of the connecting plate 320 is less than a length of the first plate body 312 along the second direction Y. Therefore, after the first heat dissipation structure 40 is mounted in the dividing assembly 30, the first heat dissipation structure 40 can be connected to the heat transfer structure through a side surface of the dividing assembly 30. In addition, the third plate body 314 and the bearing plate 321 are located on a same plane, and both can be configured to bear the first heat dissipation structure 40. The second plate body 313 can limit movement of the first heat dissipation structure 40 along the second direction Y.

It should be noted that a plurality of holes may be disposed in the second plate body 313, so that air enters the housing through the holes, to improve the heat dissipation capability of the first heat dissipation structure. At least one connecting plate 320 includes a limiting opening 322. The limiting opening 322 extends along the third direction Z. The limiting opening 322 is configured to be connected to the first heat dissipation structure 40, to ensure stability when the first heat dissipation structure 40 ascends or descends along the third direction. A quantity of limiting openings 322 may be specifically adjusted based on an actual condition.

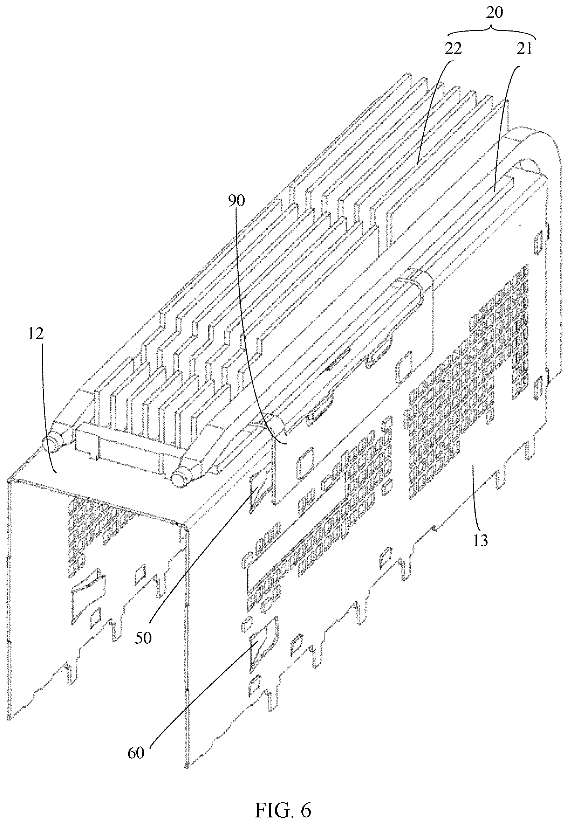

FIG. 6 is a partial schematic structural diagram of a housing in a heat dissipation apparatus according to an embodiment of this application. With reference to FIG. 6, in the foregoing embodiment, at least one group of first elastic clamping parts 50 and at least one group of second elastic clamping parts 60 are also disposed in the housing 10. One group of first elastic clamping parts 50 includes two first elastic clamping parts 50, and one group of second elastic clamping parts 60 includes two second elastic clamping parts 60. The at least one group of first elastic clamping parts 50 is disposed in the first sub receiving cavity, and the at least one group of second elastic clamping parts 60 is disposed in the second sub receiving cavity. Specifically, at least one first elastic clamping part 50 is disposed on each first side plate 130, and disposition of the first elastic clamping part 50 can limit movement of the plug-in terminal of the optical module in the first sub receiving cavity along the first direction X. Similarly, at least one second elastic clamping part 60 is disposed on each first side plate 130, and disposition of the second elastic clamping part 60 can limit movement of the plug-in terminal of the optical module in the second sub receiving cavity along the first direction X. Each of the first elastic clamping part 50, the second elastic clamping part 60, and the first elastic part may be an elastic tap or other elastic structural part.

The heat dissipation apparatus includes a fastening assembly 90, and the fastening assembly 90 can fix the top plate 12 to the second heat dissipation structure 20. When the second heat dissipation structure 20 is specifically connected to the top plate 12, an opening configured to receive the second heat dissipation structure 20 may be disposed on the top plate 12, and part of the second heat dissipation structure 20 is disposed in the opening of the top plate 12. The fastening assembly fastens the second heat dissipation structure 20 to the top plate 12, and a space exists between the fastening assembly and the second heat dissipation structure 20, so that the second heat dissipation structure 20 can move close to or away from the bottom plate relative to the top plate 12. The fastening assembly 90 may be specifically a pressing fastening structure, and the pressing fastening structure is a spring, an elastic tap, a fastener, or the like.

In the foregoing embodiment, the second heat dissipation structure 20 includes a second heat dissipation main plate 21, and the second heat dissipation main plate 21 is configured to be connected to the top plate 12, to dissipate heat for the plug-in terminal inserted in and connected to the first sub receiving cavity. In some other embodiments, the second heat dissipation structure 20 further includes a plurality of second heat dissipation fin groups 22, and the plurality of second heat dissipation fin groups 22 are disposed at intervals along the second direction Y on one side that is of the second heat dissipation main plate 21 and that faces away from the top plate 12.

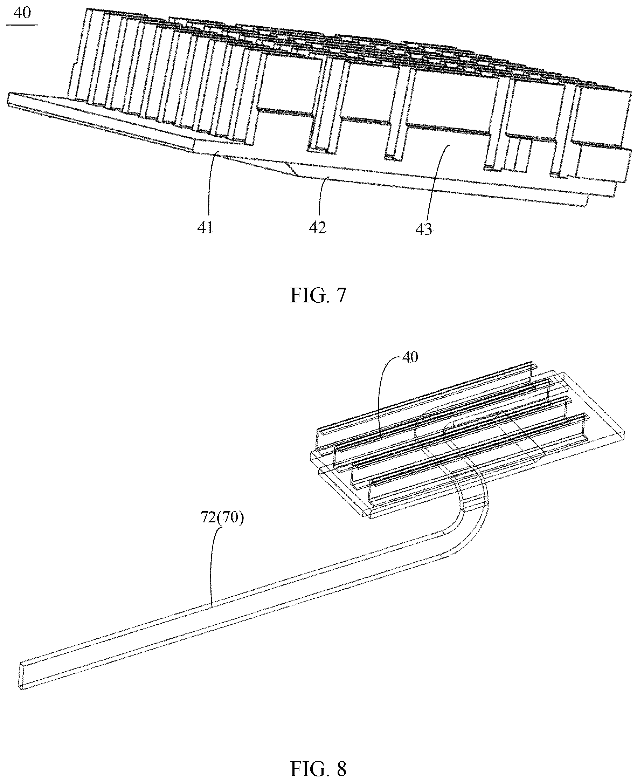

FIG. 7 is a schematic structural diagram of a first heat dissipation structure in a heat dissipation apparatus according to an embodiment of this application. With reference to FIG. 7, the first heat dissipation structure 40 includes a first heat dissipation main plate 41, a contact plate 42, and a limiting block. The contact plate 42 is disposed on one side that is of the first heat dissipation main plate 41 and that faces toward the bottom plate. The contact plate 42 is configured to abut against the plug-in terminal inserted in and connected to the second sub receiving cavity, to dissipate heat for the plug-in terminal. The limiting block is connected to a side surface of the first heat dissipation main plate 41, and the limiting block is configured to cooperate with a limiting opening, to ensure that the first heat dissipation structure can move along the third direction when abutting against the plug-in terminal. The first heat dissipation structure 40 includes a first heat dissipation fin group 43, and a plurality of first heat dissipation fin groups 43 are disposed on one side that is of the first heat dissipation main plate 41 and that faces toward the top plate, to improve a heat dissipation capability of the first heat dissipation main plate 41.

FIG. 8 is a schematic structural diagram of a connection between a first heat dissipation structure and a first heat transfer structure in a heat dissipation apparatus according to an embodiment of this application. With reference to FIG. 8, the first heat transfer structure 70 includes a first heat pipe 72, and the first heat pipe 72 is in a flat shape, to increase a contact area between the first heat pipe 72 and the first heat dissipation structure 40. One end of the first heat pipe 72 is connected to the first heat dissipation structure 40, and another end of the first heat pipe 72 is configured to be connected to the heat exchange apparatus. In this case, the heat exchange apparatus may be a cold plate, the cold plate exchanges heat with the first heat pipe 72, and the first heat pipe 72 exchanges heat with the first heat dissipation structure 40. The first heat pipe 72 may be configured to be connected to the heat exchange apparatus through the side plate.

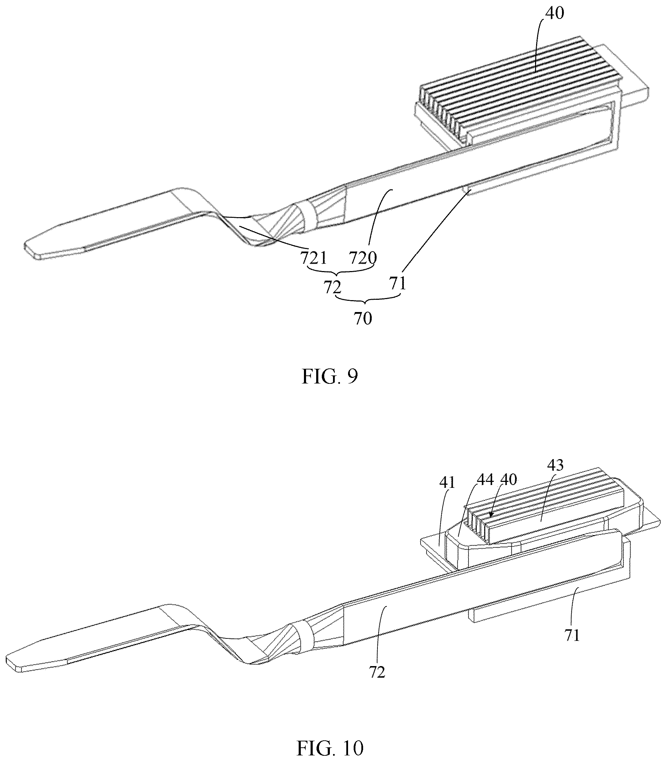

FIG. 9 is another schematic structural diagram of a connection between a first heat dissipation structure and a first heat transfer structure in a heat dissipation apparatus according to an embodiment of this application. With reference to FIG. 9, the first heat transfer structure 70 includes a heat transfer baseplate 71 and a first heat pipe 72. The heat transfer baseplate 71 is configured to be connected to the first heat dissipation structure 40, and the first heat pipe 72 is in a flat shape, to increase a contact area between the first heat pipe 72 and the first heat dissipation structure 40. Specifically, the heat transfer baseplate 71 is disposed on an outer side of a side plate 13, and the heat transfer baseplate 71 is fixed on the side plate 13. In this case, the side plate 13 is a first side plate, and the heat transfer baseplate 71 is connected to the first heat dissipation structure 40 through the first side plate. One end of the first heat pipe 72 is fixedly connected to one side that is of the heat transfer baseplate 71 and that faces or away from the side plate 13, and the other end of the first heat pipe 72 is configured to be connected to the heat exchange apparatus, to ensure that heat absorbed by the first heat dissipation structure 40 is transferred to the external heat exchange apparatus through the first heat pipe 72.

FIG. 10 is another schematic structural diagram of a connection between a first heat dissipation structure and a first heat transfer structure in a heat dissipation apparatus according to an embodiment of this application. With reference to FIG. 10, in an embodiment, the first heat dissipation structure 40 may further include a liquid cooling radiator 44. The liquid cooling radiator 44 is disposed between the first heat dissipation main plate 41 and the first heat dissipation fin group 43. One end of the first heat pipe 72 is fixed to the heat transfer baseplate 71, and the first heat pipe 72 can be in contact with the liquid cooling radiator 44, to improve the heat dissipation capability of the first heat dissipation structure 40.

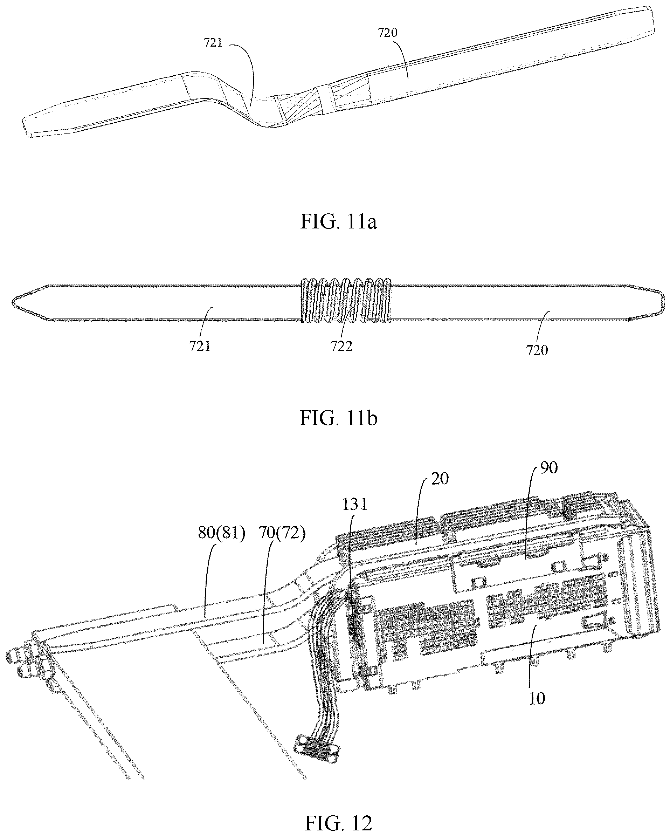

FIG. 11a is a schematic structural diagram of a first heat pipe according to an embodiment of this application. With continued reference to FIG. 9, FIG. 10, and FIG. 11a, the first heat pipe 72 includes a first pipe body 720 and a second pipe body 721 that communicate with each other, the first pipe body 720 is disposed in parallel with the heat transfer baseplate 71, the second pipe body 721 is disposed at an angle with the first pipe body 720, and at least part of the second pipe body 721 is disposed in parallel with the bottom plate. Specifically, the second pipe body 721 and the first pipe body 720 may be disposed perpendicularly to each other. In this disposition, if there are a plurality of housings, the disposition of the first pipe body 720 can reduce a spacing between two adjacent housings, and the disposition of the second pipe body 721 can improve convenience of a connection between the second pipe body 721 and the heat exchange apparatus and can further improve flexibility of floating of the second pipe body 721 along the third direction Z.

FIG. 11b is another schematic structural diagram of a first heat pipe according to an embodiment of this application. The first heat pipe includes a first pipe body 720, a flexible connection pipe body 722, and a second pipe body 721, the flexible connection pipe body 722 is configured to communicate between the first pipe body 720 to the second pipe body 721, and the first pipe body 720 is configured to be connected to the heat transfer baseplate. Specifically, when the heat transfer baseplate is disposed on an outer side of a side plate, the first pipe body 720 is configured to fixedly be connected to one side that is of the heat transfer baseplate and that faces toward or away from the side plate, and the second pipe body 721 is configured to be connected to the heat exchange apparatus. In this disposition, when the first pipe body 720 is connected to the heat transfer baseplate, the first pipe body 720 can be disposed in parallel with the heat transfer baseplate, to increase efficiency of heat transfer. A contact area between the second pipe body 721 and the heat exchange apparatus is relatively large, so that efficiency of heat transfer of the first heat pipe is relatively high.

FIG. 12 is another schematic structural diagram of a heat dissipation apparatus according to an embodiment of this application. With reference to FIG. 12, the heat dissipation apparatus includes a second heat transfer structure 80. The second heat transfer structure 80 includes a second heat pipe 81, one end of the second heat pipe 81 is connected to the second heat dissipation structure 20, and another end of the second heat pipe 81 is connected to the heat exchange apparatus. The second heat pipe 81 is in a flat shape, to improve a heat dissipation capability of the second heat transfer structure 80 with respect to the second heat dissipation structure 20. The first heat transfer structure 70 includes a first heat pipe 72, one end of the first heat pipe 72 is connected to the first heat dissipation structure 40, the other end of the first heat pipe 72 is connected to the heat exchange apparatus through the second side plate 131, and the other end of the first heat pipe 72 and the other end of the second heat pipe 81 are disposed along the third direction at two ends of the heat exchange apparatus. Alternatively, the other end of the first heat pipe 72 and the other end of the second heat pipe 81 are disposed on a same side of the heat exchange apparatus.

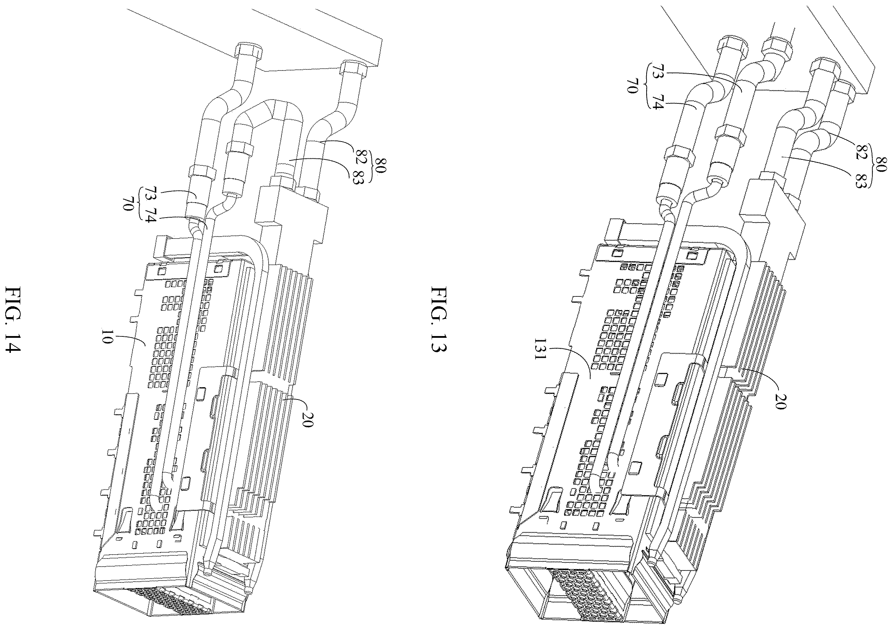

FIG. 13 is another schematic structural diagram of a heat dissipation apparatus according to an embodiment of this application. With reference to FIG. 13, the first heat transfer structure 70 includes a first liquid inlet pipe 73 and a first liquid outlet pipe 74, one end of the first liquid inlet pipe 73 communicates with the first heat dissipation structure through the housing, another end of the first liquid inlet pipe 73 is configured to communicate with the heat exchange apparatus, and one end of the first liquid outlet pipe 74 communicates with the first heat dissipation structure through the housing. Specifically, one end of the first liquid inlet pipe 73 may be connected to the first heat dissipation structure through a side plate (the side plate is a first side plate 130), one end of the first liquid outlet pipe 74 may communicate with the first heat dissipation structure through a side plate (the side plate is a first side plate 130), and another end of the first liquid outlet pipe 74 is configured to communicate with the heat exchange apparatus. The second heat transfer structure 80 includes a second liquid inlet pipe 82 and a second liquid outlet pipe 83, one end of the second liquid inlet pipe 82 communicates with the second heat dissipation structure 20, another end of the second liquid inlet pipe 82 is configured to communicate with the heat exchange apparatus, one end of the second liquid outlet pipe 83 communicates with the second heat dissipation structure 20, and the other end of the second liquid inlet pipe 82 communicates with the first heat dissipation structure 40. In this manner, the second heat dissipation structure 20 and the first heat dissipation structure are connected to the heat exchange apparatus respectively through the second heat transfer structure 80 and the first heat transfer structure 70, and both the second heat transfer structure 80 and the first heat transfer structure 70 enable a coolant medium to flow into the second heat dissipation structure 20 and the first heat dissipation structure through a flow line, to improve heat dissipation efficiency of the second heat dissipation structure 20 and the first heat dissipation structure.

FIG. 14 is another schematic structural diagram of a heat dissipation apparatus according to an embodiment of this application. With reference to FIG. 14, the first heat transfer structure 70 includes a first liquid inlet pipe 73 and a first liquid outlet pipe 74, and the second heat transfer structure 80 includes a second liquid inlet pipe 82 and a second liquid outlet pipe 83. One end of the second liquid inlet pipe 82 communicates with the second heat dissipation structure 20, another end of the second liquid inlet pipe 82 is configured to communicate with the heat exchange apparatus, one end of the second liquid outlet pipe 83 communicates with the second heat dissipation structure 20, another end of the second liquid outlet pipe 83 communicates with one end of the first liquid inlet pipe 73, another end of the first liquid inlet pipe 73 communicates with the first heat dissipation structure, one end of the first liquid outlet pipe 74 communicates with the first heat dissipation structure, and another end of the first liquid outlet pipe 74 is configured to communicate with the heat exchange apparatus. In this manner, the first heat dissipation structure and the second heat dissipation structure are connected in series through the second liquid outlet pipe 83 and the first liquid inlet pipe 73, and the coolant medium flows back to the heat exchange apparatus through the second liquid inlet pipe 82, the second heat dissipation structure 20, the second liquid outlet pipe 83, the first liquid inlet pipe 73, the first heat dissipation structure, and the first liquid outlet pipe 74, to complete heat dissipation for the second heat dissipation structure and the first heat dissipation structure. Specifically, both the first liquid outlet pipe 74 and the first liquid inlet pipe 73 may communicate with the first heat dissipation structure through the side plate.

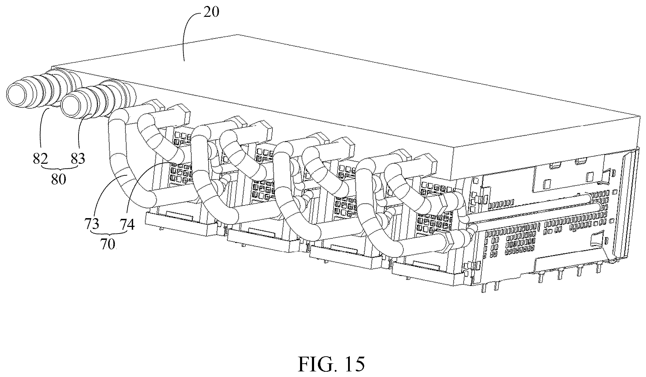

FIG. 15 is another schematic structural diagram of a heat dissipation apparatus according to an embodiment of this application. With reference to FIG. 15, the first heat transfer structure 70 includes a first liquid inlet pipe 73 and a first liquid outlet pipe 74, and the second heat transfer structure 80 includes a second liquid inlet pipe 82 and a second liquid outlet pipe 83. One end of the first liquid inlet pipe 73 communicates with the first heat dissipation structure through the side plate, another end of the first liquid inlet pipe 73 communicates with the second heat dissipation structure 20, one end of the first liquid outlet pipe 74 communicates with the first heat dissipation structure, and another end of the first liquid outlet pipe 74 communicates with the second heat dissipation structure 20. One end of the second liquid inlet pipe 82 communicates with the second heat dissipation structure 20, another end of the second liquid inlet pipe 82 is configured to communicate with the heat exchange apparatus, one end of the second liquid outlet pipe 83 communicates with the second heat dissipation structure 20, and another end of the second liquid outlet pipe 83 communicates with the heat exchange apparatus. In this manner, the coolant medium enters the second heat dissipation structure 20 through the second liquid inlet pipe 82, the first liquid inlet pipe 73 communicates with the second heat dissipation structure 20 to convey the coolant medium to the first heat dissipation structure, and the coolant medium that absorbs heat in the first heat dissipation structure flows back to the second heat dissipation structure 20 through the first liquid outlet pipe 74, and then flows back to the heat exchange apparatus through the second liquid outlet pipe 84.

In some embodiments, a size of the second heat dissipation structure is relatively large, each second heat dissipation structure may be connected to top plates of a plurality of housings, the plurality of housings are arranged at intervals, and the first heat dissipation structure in each housing communicates with the second heat dissipation structure 20 through a first liquid inlet pipe 73 and a first liquid outlet pipe 74.

In an embodiment, all of the first liquid inlet pipe 73, the first liquid outlet pipe 74, the second liquid inlet pipe 82, and the second liquid outlet pipe 83 may be hoses.

This application further provides a heat dissipation system. The heat dissipation system includes a heat exchange apparatus and a plurality of heat dissipation apparatuses, where the plurality of heat dissipation apparatuses are sequentially disposed at intervals, and a first heat transfer structure and a second heat transfer structure included in each heat dissipation apparatus are both connected to the heat exchange apparatus. In this disposition, when a plug-in terminal of an optical module is inserted in and connected to each heat dissipation apparatus, because a second heat dissipation structure and a first heat dissipation structure in each heat dissipation apparatus are both capable of moving, it can be ensured that the heat dissipation system is applicable to optical modules with plug-in terminals in different sizes, and further, applicability of the heat dissipation system can be improved.

This application further provides a heat dissipation system, including a heat dissipation apparatus and at least one optical module, where the optical module includes a body and plug-in terminals connected to the body, and the plug-in terminals are inserted in and connected to a first sub receiving cavity and a second sub receiving cavity included in the heat dissipation apparatus. In this manner, heat generated by the plug-in terminal of the optical module can be quickly dissipated, and a service life of the optical module is prolonged.

Apparently, a person skilled in the art may make various changes and variations to the embodiments of this application without departing from the spirit and scope of the embodiments of the present invention. Therefore, the present invention is intended to cover the changes and variations provided that the changes and variations of the embodiments of the present invention fall within the scope of the claims of the present invention or equivalent technologies thereof.

## Claims

1. A heat dissipation apparatus, comprising a housing, at least one dividing assembly, at least one first heat dissipation structure, and at least one first heat transfer structure, wherein
the housing comprises a bottom plate, a top plate, and a side plate, the side plate is configured to connect the top plate to the bottom plate, a receiving cavity with an opening at one end is formed by an enclosure of the top plate, the bottom plate, and the side plate, the at least one dividing assembly is located in the receiving cavity, and the at least one dividing assembly is configured to divide the receiving cavity into a first sub receiving cavity and at least one second sub receiving cavity;
one side of the first heat dissipation structure and facing toward the bottom plate is located in the second sub receiving cavity; and
one end of the first heat transfer structure is connected to the first heat dissipation structure, and another end of the first heat transfer structure is configured to be connected to a heat exchange apparatus through the housing.

2. The heat dissipation apparatus according to claim 1, wherein the other end of the first heat transfer structure is connected to the heat exchange apparatus through the side plate.

3. The heat dissipation apparatus according to claim 1 or 2, wherein the first heat transfer structure comprises a first heat pipe, the first heat pipe is in a flat shape, one end of the first heat pipe is connected to the first heat dissipation structure, and another end of the first heat pipe is configured to be connected to the heat exchange apparatus.

4. The heat dissipation apparatus according to claim 1, wherein the first heat transfer structure comprises a heat transfer baseplate and a first heat pipe, the first heat pipe is flat-shaped, the heat transfer baseplate is connected to the first heat dissipation structure, one end of the first heat pipe is fixedly connected to one side of the heat transfer baseplate, and another end of the first heat pipe is configured to be connected to the heat exchange apparatus.

5. The heat dissipation apparatus according to claim 4, wherein the first heat pipe comprises a first pipe body and a second pipe body that communicate with each other, the first pipe body is disposed in parallel with the heat transfer baseplate, the first pipe body is fixedly connected to the heat transfer baseplate, the second pipe body is disposed at an angle with the first pipe body, and the second pipe body is configured to be connected to the heat exchange apparatus.

6. The heat dissipation apparatus according to claim 4, wherein the first heat pipe comprises a first pipe body, a flexible connection pipe body, and a second pipe body, the flexible connection pipe body is configured to communicate between the first pipe body and the second pipe body, the first pipe body is configured to fixedly be connected to the heat transfer baseplate, and the second pipe body is configured to be connected to the heat exchange apparatus.

7. The heat dissipation apparatus according to claim 1, wherein each dividing assembly is configured to mount one first heat dissipation structure.

8. The heat dissipation apparatus according to claim 1, wherein the heat dissipation apparatus comprises a second heat dissipation structure, and the second heat dissipation structure is connected to one side that is of the top plate and that faces away from the bottom plate.

9. The heat dissipation apparatus according to claim 1, wherein the heat dissipation apparatus comprises a second heat transfer structure, and the second heat transfer structure is connected to the second heat dissipation structure.

10. The heat dissipation apparatus according to claim 9, wherein the first heat transfer structure comprises a first liquid inlet pipe and a first liquid outlet pipe, one end of the first liquid inlet pipe communicates with the first heat dissipation structure through the side plate, another end of the first liquid inlet pipe is configured to communicate with the heat exchange apparatus, one end of the first liquid outlet pipe communicates with the first heat dissipation structure through the housing, and another end of the first liquid outlet pipe is configured to communicate with the heat exchange apparatus; and
the second heat transfer structure comprises a second liquid inlet pipe and a second liquid outlet pipe, one end of the second liquid inlet pipe communicates with the second heat dissipation structure, another end of the second liquid inlet pipe is configured to communicate with the heat exchange apparatus, one end of the second liquid outlet pipe communicates with the second heat dissipation structure, and another end of the second liquid inlet pipe communicates with the first heat dissipation structure.

11. The heat dissipation apparatus according to claim 9, wherein the first heat transfer structure comprises a first liquid inlet pipe and a first liquid outlet pipe, and the second heat transfer structure comprises a second liquid inlet pipe and a second liquid outlet pipe; and
one end of the second liquid inlet pipe communicates with the second heat dissipation structure, another end of the second liquid inlet pipe is configured to communicate with the heat exchange apparatus, one end of the second liquid outlet pipe communicates with the second heat dissipation structure, another end of the second liquid outlet pipe communicates with one end of the first liquid inlet pipe, another end of the first liquid inlet pipe communicates with the first heat dissipation structure, one end of the first liquid outlet pipe communicates with the first heat dissipation structure through the housing, and another end of the first liquid outlet pipe is configured to communicate with the heat exchange apparatus.

12. The heat dissipation apparatus according to claim 9, wherein the first heat transfer structure comprises a first liquid inlet pipe and a first liquid outlet pipe, and the second heat transfer structure comprises a second liquid inlet pipe and a second liquid outlet pipe;
one end of the first liquid inlet pipe communicates with the first heat dissipation structure through the housing, another end of the first liquid inlet pipe communicates with the second heat dissipation structure, one end of the first liquid outlet pipe communicates with the first heat dissipation structure through the housing, and another end of the first liquid outlet pipe communicates with the second heat dissipation structure; and
one end of the second liquid inlet pipe communicates with the second heat dissipation structure, another end of the second liquid inlet pipe is configured to communicate with the heat exchange apparatus, one end of the second liquid outlet pipe communicates with the second heat dissipation structure, and another end of the second liquid outlet pipe communicates with the heat exchange apparatus.

13. The heat dissipation apparatus according to any one of claims 9 to 12, wherein the first heat dissipation structure is capable of moving close to or away from the bottom plate relative to the dividing assembly; and the second heat dissipation structure is capable of moving close to or away from the bottom plate relative to the top plate.

14. The heat dissipation apparatus according to any one of claims 9 to 12, wherein the housing has a plurality of housings, and the second heat dissipation structure is connected to top plates comprised in the plurality of housings.

15. A heat dissipation system, comprising a heat exchange apparatus and a plurality of heat dissipation apparatuses according to any one of claims 1 to 13, wherein the plurality of heat dissipation apparatuses are sequentially disposed at intervals, and a first heat transfer structure and a second heat transfer structure comprised in each of the heat dissipation apparatuses are both connected to the heat exchange apparatus.

16. A heat dissipation device for an optical module, comprising the heat dissipation apparatus according to any one of claims 1 to 14 and at least one optical module, wherein the optical module comprises a body and plug-in terminals connected to the body, and the plug-in terminals are inserted in and connected to a first sub receiving cavity and a second sub receiving cavity comprised in the heat dissipation apparatus.
